(19) Europäisches Patentamt
European Patent Office
Office européen des brevets

(11) EP 2 571 073 A2

(12) # EUROPEAN PATENT APPLICATION

(43) Date of publication:
**20.03.2013 Bulletin 2013/12**

(51) Int Cl.:
***H01L 51/50*** *(2006.01)* ***H01L 51/52*** *(2006.01)*

(21) Application number: **12161253.5**

(22) Date of filing: **26.03.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **16.09.2011 JP 2011202828**

(71) Applicant: **Kabushiki Kaisha Toshiba**
**Tokyo 105-8001 (JP)**

(72) Inventors:
- **Sawabe, Tomoaki**
  **Tokyo, 105-8001 (JP)**
- **Takasu, Isao**
  **Tokyo, 105-8001 (JP)**
- **Ono, Tomio**
  **Tokyo, 105-8001 (JP)**
- **Yonehara, Toshiya**
  **Tokyo, 105-8001 (JP)**
- **Enomoto, Shintaro**
  **Tokyo, 105-8001 (JP)**

(74) Representative: **HOFFMANN EITLE**
**Patent- und Rechtsanwälte**
**Arabellastrasse 4**
**81925 München (DE)**

(54) **Organic electroluminescent device, display and lighting instrument**

(57) The organic electroluminescent device according to the embodiment has: anode and cathode electrodes placed apart from each other, a red and green light-emitting layer and a blue light-emitting layer, and a spacer layer having a thickness of 3 nm to 20 nm inclusive. The light-emitting layers are placed apart from each other and positioned between the electrodes. The spacer layer is positioned between the light-emitting layers, and includes a carrier transport material containing molecules capable of being oriented in the in-plane and vertical direction with an orientational order parameter of -0.5 to -0.2 inclusive.

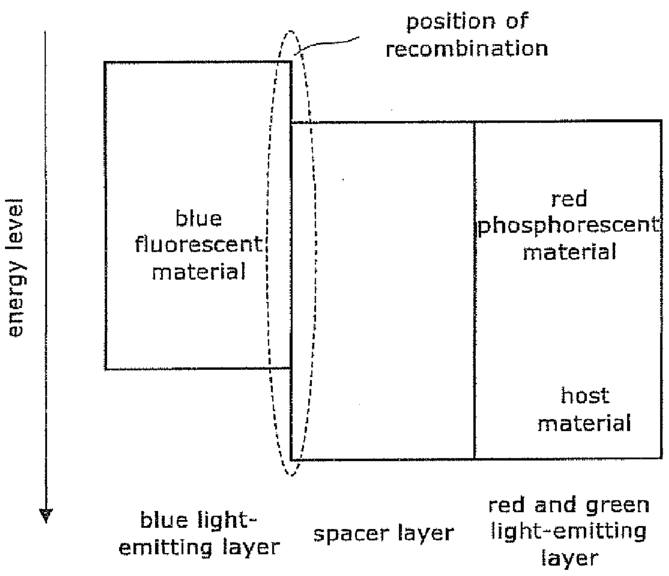


FIG. 2

EP 2 571 073 A2

## Description

CROSS REFERENCE TO RELATED APPLICATIONS

This application is based upon and claims the benefit of priority from the prior Japanese Patent Application No. 2011-202828, filed on September 16, 2011; the entire contents of which are incorporated herein by reference.

FIELD

The present embodiment relates to an organic electroluminescent device, and also to its uses in a display and in a lighting instrument.

BACKGROUND

Recently, organic electroluminescent devices (hereinafter, often referred to as "organic EL devices") have attracted the attention of people as flat panel lighting sources. Generally, an organic electroluminescent device comprises a light-emitting layer which is made of organic materials and which is provided between a pair of cathode and anode. When electric voltage is applied between the cathode and anode, electrons and holes are injected into the light-emitting layer from the cathode and anode, respectively. In the light-emitting layer, the injected electrons and holes recombine to form excitons, which undergo radiative deactivation to emit light.

Light-emitting materials used in organic EL devices are roughly categorized into two types, namely, fluorescent materials and phosphorescent ones. As for the fluorescent tight-emitting materials, there are already known long-life and reliable materials that give off any of blue, green and red light. However, since the fluorescent material converts only singlet excitons into light emission, the internal quantum efficiency thereof is theoretically limited up to about 25%. In contrast, since the phosphorescent light-emitting material can convert both singlet and triplet excitons into light emission, the internal quantum efficiency thereof is theoretically expected to be almost 100%. However, although green and red phosphorescent materials having sufficient lifetimes are already known, there are scarcely any blue phosphorescent materials that have sufficient lifetimes and that satisfy requirements on cost and performances.

Meanwhile, white organic EL devices are studied to use as lighting instruments or backlights for displays. Generally, a white organic EL device emits white light by use of a combination of red, green and blue light-emitting materials, Accordingly, if phosphorescent materials are adopted as all the red, green and blue light-emitting materials, the organic EL device is expected to have high luminous efficiency. However, since not having sufficient material-lifetime as described above, the blue phosphorescent material is liable to shorten the device-lifetime of the white organic EL device employing it, and hence often lowers the reliability thereof.

To solve the above problem, attempts have been made to produce a long-life and reliable white organic EL device comprising a blue light-emitting layer and a red and green light-emitting layer stacked thereon provided that the blue light-emitting layer contains a long-life blue fluorescent material and the red and green light-emitting layer contains phosphorescent materials. In this device, the blue light-emitting layer gives off light induced only by singlet excitons. If triplet excitons formed in the blue light-emitting layer can be kept from thermal deactivation and diffused intact into the red and green light-emitting layer, the energy of the triplet excitons can be utilized for emission from the red and green phosphorescent materials. This technique is referred to as "triplet harvesting", which theoretically makes it possible to increase the internal quantum efficiency up to 100% even though the fluorescent light-emitting material is partly employed. Accordingly, it is expected to realize a long-life and highly reliable white organic EL device by use of triplet harvesting.

In the organic EL device using triplet harvesting, it is necessary to provide a spacer layer between the blue fluorescent layer and the red and green phosphorescent layer so as to efficiently utilize both singlet and triplet excitons. The spacer layer has functions of making the singlet excitons stay in the blue fluorescent layer to convert them effectively into blue emission and, at the same time, of diffusing only the triplet excitons into the red and green phosphorescent layer. This means that the spacer layer has suitable single and triplet energy states (Sl) and (T1), respectively. In the field of research on triplet harvesting, various efforts have been made to improve the structure and/or materials of the device for the purpose of obtaining efficient white emission. Even so, however, not enough studies have been conducted on the spacer layer in view of efficient triplet diffusion.

BRIEF DESCRIPTION OF THE DRAWINGS

Figure 1 schematically shows a sectional view of an organic EL device according to the embodiment.
Figure 2 shows a HOMO-LUMO energy diagram of an organic EL device according to the embodiment.

Figure 3 is an energy diagram schematically illustrating singlet excited state energy levels, triplet excited state energy levels and exciton energy transfers in an organic EL device according to the embodiment.
Figure 4 is a circuit diagram of a display according the embodiment.
Figure 5 schematically shows a sectional view of a lighting instrument according to the embodiment.
Figure 6 is a graph showing voltage-dependent external quantum efficiencies of the organic EL devices produced in Example and Comparative Examples,
Figure 7 shows emission spectra of the organic EL devices produced in Example and Comparative Examples.
Figure 8 is a graph showing device-characteristics of the organic EL devices produced in Example and Comparative Examples.
Figure 9 shows emission spectra of the organic EL devices produced in Example and Comparative Examples.

DETAILED DESCRIPTION

Embodiments will now be explained with reference to the accompanying drawings.

The organic EL device according to the embodiment comprises: anode and cathode electrodes placed apart from each other, a red and green light-emitting layer and a blue light-emitting layer which are placed apart from each other and which are positioned between the electrodes, and a spacer layer which has a thickness of 3 nm to 20 nm inclusive and which is positioned between the light-emitting layers. The spacer layer comprises a carrier transport material containing molecules capable of being oriented in the in-plane and vertical direction with an orientational order parameter of -0.5 to -0.2 inclusive.

The embodiment is described below with reference to Figures 1, 2 and 3.

Figure 1 schematically shows a sectional view of an organic EL device according to the embodiment.

In Figure 1, an organic EL device 10 comprises a substrate 11. On one main face of the substrate 11, an anode 12, a hole transport layer 13, a light-emitting layer 14, an electron transport layer 15, an electron injection layer 16 and a cathode 17 are stacked in this order. The light-emitting layer 14 comprises a blue light-emitting layer 14c, a red and green light-emitting layer 14a and a spacer layer 14b sandwiched between the layers 14a and 14c. The positions of the layers 14a and 14c may be exchanged for each other, if necessary. The hole transport layer 13, the electron transport layer 15 and the electron injection layer 16 are optionally provided according to necessity. The spacer layer 14b has suitable singlet and triplet energy states (hereinafter, referred to as S1 and T1, respectively). The hole transport layer 13, the light-emitting layer 14, the electron transport layer 15 and the electron injection layer 16 are laid parallel to the main face of the substrate, and also the blue light-emitting layer 14c, the red and green light-emitting layer 14a and the spacer layer 14b are laid parallel to the main face of the substrate.

Figure 2 shows a HOMO-LUMO energy diagram of the blue light-emitting layer 14c, the spacer layer 14b and the red and green light-emitting layer 14a in the organic EL device according to the embodiment. Figure 3 is an energy diagram schematically illustrating singlet excited state energy levels, triplet excited state energy levels and exciton energy transfers of the blue light-emitting layer 14c, the spacer layer 14b and the red phosphorescent light-emitting layer in the organic EL device according to the embodiment.

In the present embodiment, the blue light-emitting layer 14c is formed of a hole transport material doped with a blue fluorescent material. The red and green light-emitting layer 14a is formed of a host material doped with red and green phosphorescent materials. For simplifying explanation for diffusion of triplet excitons, the energy diagram in Figure 2 illustrates energy states of the red and green light-emitting layer 14a only by showing energy levels of the red phosphorescent material used therein. Actually, however, the embodiment also employs the green phosphorescent material, which has almost the same energy-related characteristics and functions as the red phosphorescent material. The spacer layer 14b comprises a carrier transport material, for example, the host material used in the red and green light-emitting layer 14a, The energy diagram in Figure 2 is for the case where the same host material is used in the spacer layer 14b and in the red and green light-emitting layer 14a, and accordingly the energy levels in the spacer layer 14b of Figure 2 are the same as those in the host material of the red and green light-emitting layer 14a.

When electric voltage is applied to the organic EL device 10, electrons and positive holes are injected and then recombined at the interface between the blue light-emitting layer 14c and the spacer layer 14b. This recombination forms excitons, 25% and 75% of which become singlet and triplet excitons, respectively.

The singlet excitons are generally thought to undergo energy transfer according to Foerster mechanism based on the dipole-dipole interaction. Since the energy transfer according to Foerster mechanism is based on the dipole-dipole interaction, the excitons can diffuse (transfer) even if molecules are not necessarily close to each other. However, the distance of the energy transfer is presumed to be not more than about 10 nm in normal materials.

The transfer of excitons is controlled by the spacer layer 14b positioned between the blue light-emitting layer 14c and the red and green light-emitting layer 14a. The spacer layer 14b has functions of preventing the singlet excitons from transferring from the blue light-emitting layer 14c to the red and green light-emitting layer 14a and, at the same time, of diffusing the triplet excitons. The mechanism of that is explained below by use of energy levels shown in Figure

3. In Figure 3, solid line arrows stand for the energy transfers of excitons. The energy levels in the blue light-emitting layer 14c and in the red and green light-emitting layer 14a are those of excitons and of the red phosphorescent material, respectively. As shown in Figure 3, the S1 energy level of the spacer layer 14b is higher than that of the blue fluorescent materials while the T1 energy level of the spacer layer 14b is lower than that of the blue fluorescent material. The spacer layer 14b in the embodiment is made to have a thickness enough to prevent energy transfer based on Foerster mechanism. Accordingly, the spacer layer 14b is too thick for the excitons to undergo energy transfer. For example, the spacer layer 14b has a thickness of 3 nm or more. Further, the T1 energy level of the spacer layer 14b is higher than that of the red and green phosphorescent materials.

Since the spacer layer 14b has a S1. energy level higher than the blue fluorescent materiels, singlet excitons formed at the interface between the blue light-emitting layer 14c and the spacer layer 14b cannot diffuse into the spacer layer 14b. In addition, since the spacer layer 14b is thick enough to prevent energy transfer based on Foerster mechanism, the excitons hardly undergo the energy transfer. Consequently, energy of the singlet excitons is consumed in generating blue fluorescence in the blue light-emitting layer 14c. The blue light-emitting layer 14c thus gives off blue fluorescence induced by the singlet excitons.

On the other hand, since the spacer layer 14b has a T1 energy level lower than the triplet excitons in the blue light-emitting layer 14c, triplet excitons diffuse into the spacer layer 14b and reach to the red and green light-emitting layer 14a. As a result, energy of the triplet excitons is consumed in generating phosphorescence in the red and green light-emitting layer 14a. The red and green light-emitting layer 14a thus gives off red and green phosphorescences. In this way, the organic EL device can emit white light by use of a combination of the blue fluorescence and the red and green phosphorescences. As described above, even though adopting a blue fluorescent material, the organic EL device according to the embodiment does not waste the energy of triplet excitons formed in the blue light-emitting layer 14c but effectively utilizes both S1 and T1 energies generated in the blue light-emitting layer 14c, and thereby realizes high luminous efficiency. To achieve high luminous efficiency, the efficient triplet diffusion in spacer layer 14b is very important. The triplet-exciton diffusion arises by the electron exchange interaction between molecules based on Dexter energy transfer. So the overlap of the molecular orbital between molecules is very important for efficient triplet-exciton diffusion.

In order that the spacer layer 14b can play well the above role, it must be formed of particular materials described below. Here, two directions are defined in the spacer layer 14b. One is a horizontal plane that is parallel to the main face of the substrate, and the other is a vertical direction that is perpendicular to the horizontal plane. In the vertical direction, the anode 12, the hole transport layer 13, the light-emitting layer 14, the electron transport layer 15, the electron injection layer 16 and the cathode 17 are stacked in this order. The spacer layer 14b comprises a carrier transport material containing planar molecules. The term "planar molecules" here means molecules having planar shapes. The planar molecules included in the spacer layer 14b form an amorphous structure in the horizontal plane and are oriented in random directions, but are oriented in the vertical direction. In other words, the planar molecules are so stacked that their planes may be parallel to the horizontal pane, to constitute the spacer layer 14b.

The planar molecules are oriented in the vertical direction. Examples of the planar molecules include 1,3-bis-2-2,2-pyridyl-1,3,4-oxadiazolylbenzene (hereinafter, often referred to as "Bpy-OXD") represented by the following formula:

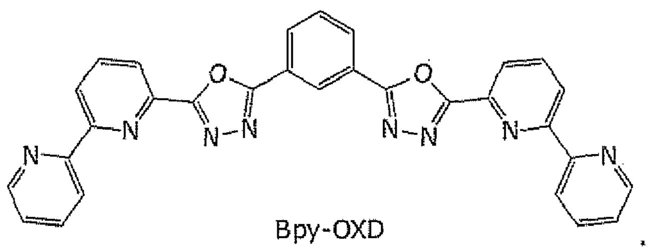

Bpy-OXD

When the spacer layer 14b is formed of Bpy-OXD molecules, the molecules are presumed to be randomly oriented in the horizontal plane but stacked one after the other in the vertical direction to form a stacking structure. The planar molecules in this arrangement are thought to have molecular orbitals largely overlapped on each other, and therefore the carrier mobility is improved in the vertical direction. Accordingly, if this spacer layer 14b is adopted, the charge carries efficiently recombine at the interface between the blue light-emitting layer 14c and the spacer layer 14b, and efficiently diffuse to phosphorescent materials, so that the organic EL device can emit light efficiently.

The alignment of plantar molecules can be generally represented by the orientational order parameter S. In the embodiment, the planar molecules in the spacer layer 14b have an orientational order parameter S of -0.5 to -0.2 inclusive.

Here, the orientational order parameter S is defined by the following formula:

$$S = \frac{1}{2}(3\cos^2\theta - 1) = \frac{k_e - k_o}{k_e + 2k_o} \qquad (1).$$

In the above formula, θ is an angle between the major axis of the molecule and the direction perpendicular to the substrate surface; and $k_0$ and $k_e$ are an ordinary extinction coefficient in the in-plane and parallel direction and an extraordinary extinction coefficient in the in-plane and vertical direction, respectively.

As shown in the formula (1), the orientational order parameter can be calculated from the values of $k_0$ and $k_e$. For obtaining the values of $k_0$ and $k_e$, measurement of variable angle spectroscopic ellipsometry is carried out and the results thereof are analyzed on the basis of a model in consideration of refractive-index anisotropy. If the molecules are placed completely parallel to the substrate, namely, if the molecules are oriented in the vertical direction, the S value is -0.5. If they are placed at random, the S value is 0. If they are placed completely perpendicularly to the substrate, namely, if they are oriented in the horizontal direction, the S value is 1.

Since the molecules are preferably oriented in the vertical direction, the S value is ideally as close to -0.5 as possible. In view of electron mobility and triplet diffusion length in the vertical direction, the S value is -0.2 or less, preferably -0.3 or less, more preferably -0.4 or less.

Examples of the carrier transport material having the above orientational order parameter, include:

1,3-bis[2-(2,2'-bipyridine-6-yl)-1,3,4-oxadizo-5-yi]-benzene (hereinafter, referred to as "Bpy-OXD"), 5==-0.44;
bis-4,6-(3,5-di-pyridylphenyl)-2-methylpyrimidine (hereinafter, referred to as "B4PyMPM"), S=-0,36;
bis-4,6-(3,5-di-pyridylphenyl)-2-phenylpyrimidine (hereinafter, referred to as "B4PyPPM"), S=-0.34;
bis-3,6-(3,5-di-pyridylphenyl)-2-methylpyrimidine (hereinafter, referred to as ""B3PyMPM'), S=-0.33;
bls-3,6-(3,5.di-pyridylphenyl)-2-phenylpyrimidine (hereinafter, referred to as "B3PyPPM"), S=-0.35;
4,4-(biphenyl-4,4-diyl)bis(4,4,4-triphenylbiphenyl-4,4-diamine) (hereinafter, referred to as "'TPT1"), S=-0.20;
4,4-(triphenyl-4,4-diyl)bis(4,4,4-triphenylbiphenyl-4,4-di amine) (hereinafter, referred to as "TPT2"), S=-0.28; and
4,4'-(triphenyl-4,4'-diyl)bis(4,4'-diphenyl-4'-mono-biphenyl-biphenyl-4,4'-diamine) (hereinafter, referred to as "TPT9"), S=-0.27,

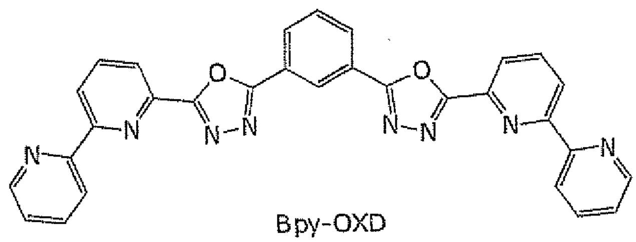

Bpy-OXD

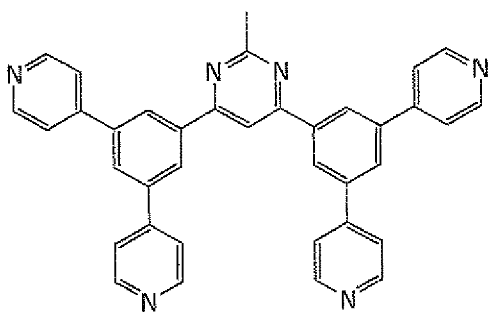

B4PyMPM

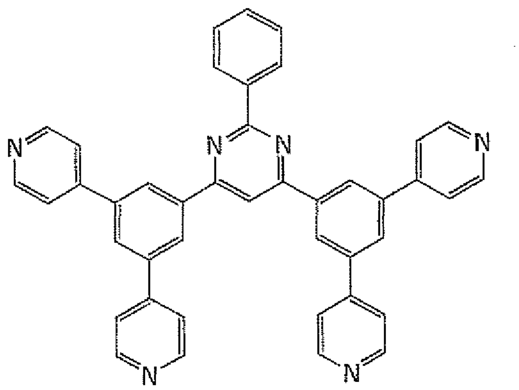

B4PyPPM

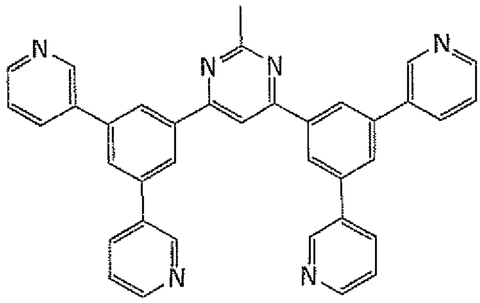

B3PyMPM

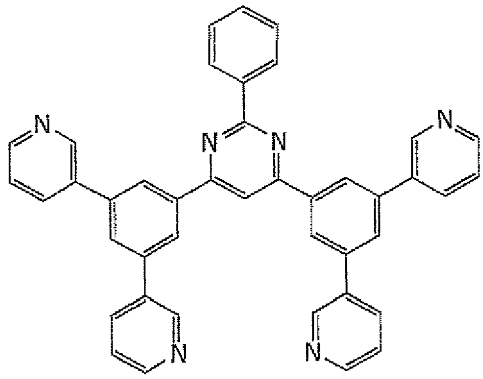

B3PyPPM

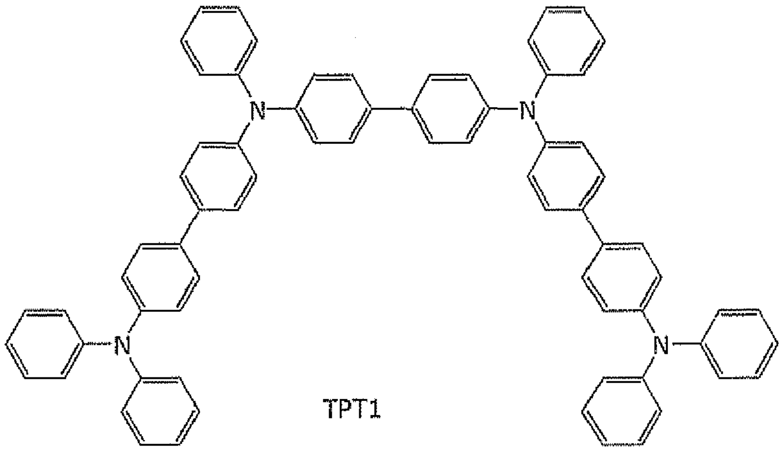

TPT1

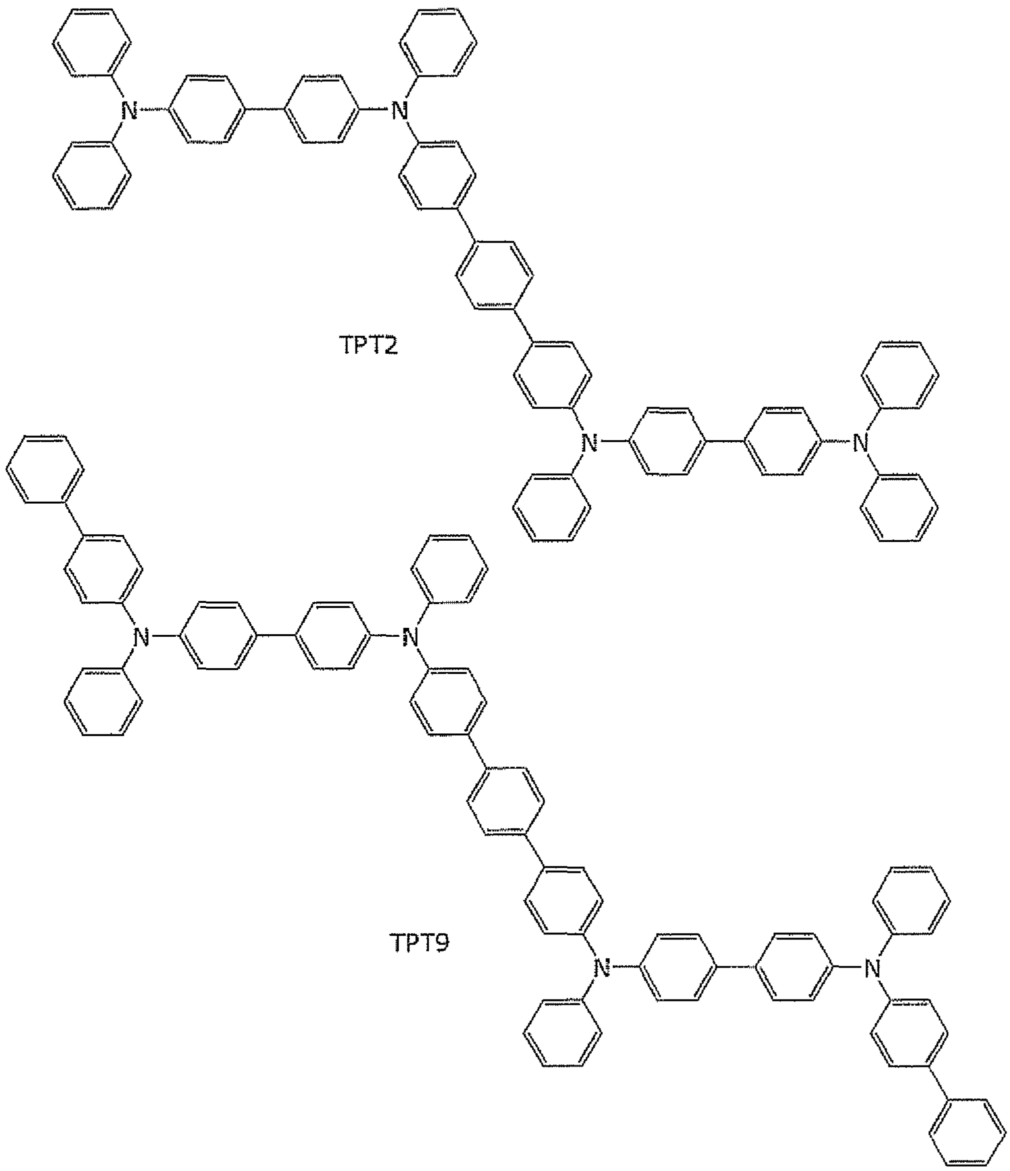

TPT2

TPT9

On the other hand, the carrier transport materials shown below are conventionally used as spacers in known organic EL devices, but the orientational order parameters (S values) thereof are too large to obtain the effect of the present embodiment. Such conventional carrier transport materials are, for example,

N,N'-di-(naphthalenyl)-N,N'-diphenyl-[1,1',4',1",4",1"'-quaterphenyl]-4,4"'-diamine (hereinafter, referred to as "4P-NPD"), S=0.1;
bis-(2-methyl-8-quinolinolate)-4-(phenylphenolato)-aluminum (hereinafter, referred to as "BAlq"), S=-0.03; and
1,3-bis[2-(4-tert-butylphenel).1,3,4-oxadiazo-5-yl]-benzene (hereinafter, referred to as "OXD-7"), S=0.01.

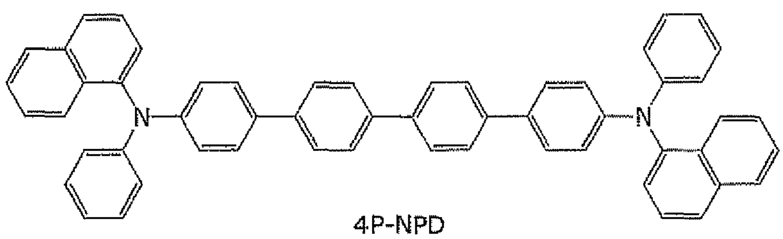

4P-NPD

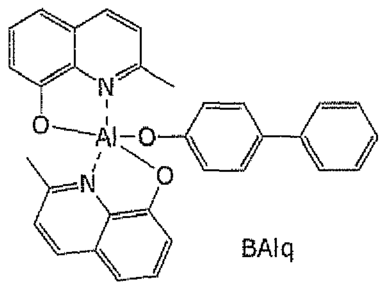

BAlq

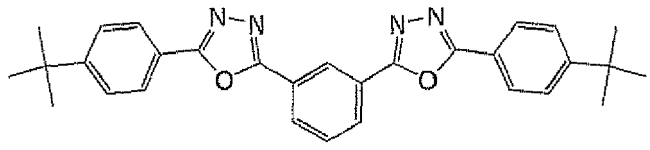

OXD-7

It is essential for the organic EL device of the embodiment to comprise the particular carrier transport material in the spacer layer 14B, but as for other elements the embodiment may employ materials used in conventional organic EL devices.

As described above, TPT1, TPT2 and TPT9, for example, are usable as a carrier transport material of the spacer layer 14B in the embodiment.

The spacer layer 14b comprising the above material must have a particular thickness to realize high efficiency. In the present embodiment, the transfers of S1 and T1 energies are dependent on the thickness of the spacer layer 14b. The thickness is, therefore, indispensably 3 nm to 20 nm inclusive, preferably 5 nm to 15 nm inclusive. The spacer layer 14b having 3 nm or more thickness can prevent long-range S1 energy transfer based on Foerster mechanism, so as to effectively make the S1 energy stay in the blue light-emitting layer. On the other hand, however, if the thickness is more than 20 nm, the triplet excitons may undergo deactivation while they are diffusing and consequently the luminous efficiency may be lowered. For this reason, the spacer layer 14b having a particular thickness enables to cause simultaneous emissions from the blue light-emitting layer 14c and from the red and green light-emitting layer 14a.

Except for the above spacer layer 14b, the organic EL device according to the present embodiment can be produced in the same manner as conventional devices. For example, conventional green, red and blue light-emitting materials can be used in the embodiment.

The red and green light-emitting layer 14a comprises a host material, a red phosphorescent light-emitting material and a green phosphorescent light-emitting material.

Examples of the red light-emitting material include: bis(2-methylbenzo-[f,h]quinoxaline)(acetylacetonato) iridium(III) (hereinafter, referred to as "Ir(MDQ)2(acac)") and tris(1-phenyl-isoquinoline)irldium(III) (hereinafter, referred to as "Ir(piq)3"). Examples of the hole-transporting host material usable in the red and green light-emitting layer 14a include: TPT1, Tut2, TPT9, bis(N-(1-naphthyl-N-phenylbenzidine (hereinafter, referred to as "a-NPD"), 1,3-bis(N-carbazolyl)-benzene (hereinafter, referred to as "mCP"), di-[4-(N,N-ditolylamino)phenyl]cyclohexane (hereinafter, referred to as "TAPC"), 4,4',4"-tris(9-carbazolyl)-triphenylamine (hereinafter, referred to as "TCTA"), and 4,4'-bis(9-carbazolyl)-2,2'-dimethylbiphenyl (hereinafter, referred to as "CDBP"). Examples of the electron -transporting host material usable in the red and green light-emitting layer 14a include: Bpy-OXD, B3PyPPM, B3PyMPM, B4PyPPM, B4PyMPM, OXD-7, BAlq, tris[3-(3-pyridyl)mesityl]-borane (hereinafter, referred to as "3TPYMB"), tris(8-hydroxy-quinolinolato)aluminum complex (Alq3), and bathophenanthroline (BPhen). Examples of the bipolar host materials usable in the red and green light-emitting layer 14a include: 4,4'-bis(9-dicarbazolyl)-2,2'-biphenyl (hereinafter, referred to as "CBP"). Those materials are nothing but examples, and hence other materials can be used if they have the same functions.

Examples of the green light-emitting material include: tris(2-phenylpyridine) iridium (III) (hereinafter, referred to as "Ir(ppy)3"), tris(2.(p-tolyl)pyridine)lridium(III) (hereinafter, referred to as "Ir(mppy)3"), and bis(2-(9,9-dihexylfuorenyl)-1-pyridine)(acetylacetonato) iridium(III) (hereinafter, referred to as "Ir(hflpy)(acac)").

The red and green light-emitting layer 14a may further contain a yellow light-emitting material. Such combination of light-emitting materials enables to obtain emission excellent in color tone.

In the embodiment described above, the red and green light-emitting layer 14a is formed of a host material doped with a red phosphorescent material and a green phosphorescent one. However, it may be constituted of two stacked sub-layers, one of which is formed of a host material doped with a red phosphorescent material and the other

of which is formed of a host material doped with a green phosphorescent material.

The blue light-emitting layer 14c may consist of only a blue fluorescent material or may comprise a host materials and a blue fluorescent material.

Examples of the blue fluorescent light-emitting material include: 1-4-dl-[4-(N,N-di-phenyl)amino]styryl-benzene (hereinafter, referred to as "DSA-Ph") and 4,4'-bis(9-ethyl-3-carbazovinylene)-1,1"biphenyl (hereinafter, referred to as "BCzVBi"). Examples of the electron-transporting host material usable in the blue light-emitting layer 14c include: 4,4-bis(2,2-diphenyl-ethene-l-yl)biphenyl (hereinafter, referred to as "DPVBi") and 9,10-bis(2-naphthyl)-2-tert-butylanthracene (hereinafter, referred to as "TBADN").

In order to keep carrier balance between electrons and holes in the light-emitting layers, electron-transporting and/or hole-transporting host materials may be further contained in the red and green light-emitting layer 14a and in the blue light-emitting layer 14c. The luminous efficiency can be improved by thus keeping the carrier balance in the light-emitting layers.

Other elements of the organic EL device according to the embodiment are explained below with reference to Figure 1.

In Figure 1, a substrate 11 supports other elements. The substrate 11 is preferably not degenerated by heat or by organic solvents. Examples of the substrate 11 include: plates of inorganic materials such as non-alkali glass and quartz glass; plates and films of plastics such as polyethylene, polyethylene terephthalate (PET), polyethylene naphthalate (PEN), polyimide, polyamide, polyamide-imide, liquid crystal polymer and cyclo-olefin polymer; and plates of metals such as stainless steel (SUS) and silicon. It is preferred to adopt a transparent substrate of glass or plastics so that light can be readily extracted. There is no particular restriction on the shape, structure and size of the substrate, and they can be suitably selected according to use and purpose. The thickness of the substrate 11 is also not restricted as long as the substrate has enough strength to support other elements.

On the substrate 11, an anode 12 is provided. The anode 12 injects electrons into a hole transport layer 13 or a light-emitting layer 14. There is no particular restriction on material of the anode 12 as long as it has electro-conductivity. The anode 12 is formally a transparent or semi-transparent electro-conductive material film formed by use of vacuum vapor deposition, sputtering, ion-plating, plating or coating. For example, an electro-conductive metal oxide film or a semi-transparent metal film can be used as the anode 12. Specifically, examples of the anode 12 include: electro-conductive glass films (e.g., NESA) made of indium oxide, zinc oxide, tin oxide and composites thereof such as indium tin oxide (ITO), fluorine-doped tin oxide (FTO) and indium zinc oxide; and films of gold, platinum, silver and copper. Particularly preferred is a transparent electrode made of ITO. Further, organic electro-conductive polymers such as polyaniline, polythiophene and derivatives thereof are also usable as the material of the electrode, The anode 12 preferably has a thickness of 30 nm to 300 nm inclusive if made of ITO. If the thickness is less than 30 nm, the conductivity decreases and the resistivity increases to lower the luminous efficiency. On the other hand, if it is more than 300 nm, the ITO anode loses flexibility and cracks when stress is applied. The anode 12 may consist either of a single layer or of two or more stacked sub-layers made of materials having different work functions.

The hole transport layer 13 is optionally provided between the anode 12 and the light-emitting layer 14. The hole transport layer 13 has functions of receiving holes from the anode 12 and of transporting them to the light-emitting layer side. The hole transport layer 13 can be made of, for example, polythiophene polymers such as poly(ethylenedioxythiophene):poly(styrene-sulfonic acid) (hereinafter, referred to as "'PEDOT:PSS,"), which is known as an electro-conductive ink. However, it by no means restrict the material of the hole transport layer 13. In fact, TCTA and α-NPD are also usable. There are also no particular restriction on the method of forming the hole transport layer 13 as long as it can form a thin film, and, for example, vacuum deposition and spin-coating can be adopted. With spin coating method, the hole transport layer 13 can be formed by the steps of: casting a material solution of the hole transport layer 13 to form a film of desired thickness and then heating the film on a hot-plate or the like. The material solution may be beforehand filtrated through a filter.

On the light-emitting layer 14, an electron transport layer 15 is optionally provided. The electron transport layer 15 has functions of receiving electrons from an electron injection layer 16 and of transporting them into the light-emitting layer 14. The electron transport layer 15 can be made of, for example, 3TPYMB, Alq3, BPhen or the like, but they by no means restrict the material of the electron transport layer 15. The electron transport layer 15 can be formed by use of vacuum vapor deposition, coating or the like.

The electron injection layer 16 is optionally provided on the electron transport layer 15. The electron injection layer 16 has functions of receiving electrons from a cathode 17 and of injecting them into the electron transport layer 15 or the light-emitting layer 14. The electron injection layer 16 can be made of, for example, CsF, LiF or the like, but they by no means restrict the material of the electron injection layer 16. The electron injection layer 16 can be formed by use of vacuum vapor deposition, coating or the like.

The cathode 17 is provided on the light-emitting layer 14 (or on the electron transport layer 15 or on the electrons injection layer 16). The cathode 17 has a function of injecting electrons into the light-emitting layer 14 (or into the electron transport layer 15 or into the electron injection layer 16). The cathode 17 is normally a transparent or semi-transparent

electro-conductive material film formed by use of vacuum vapor deposition, sputtering, ion-plating, plating or coating. For example, an electro-conductive metal oxide film or a semi-transparent metal film can be used as the cathode 17. If the anode 12 is made of a material having a high work function, the cathode 17 is preferably made of a material having a low work function. Examples of the material having a low work function include alkali metals and alkaline earth metals. Specifically, they are, for example, Li, In, Al, Ca, Mg, Na, K, Yb, Cs and the like.

The cathode 17 may consist either of a single layer or of two or more stacked sub-layers made of materials having different work functions. Further, alloys of two or more metals are also usable. Examples of the alloys include: lithium-aluminum alloy, lithium-magnesium alloy, lithium-indium alloy, magnesium-silver alloy, magnesium-indium alloy, magnesium-aluminum alloy, indium-silver alloy and calcium-aluminum alloy.

The cathode 17 preferably has a thickness of 10 nm to 150 nm inclusive. If the thickness is less than that range, the resistivity increases too much. On the other hand, if the thickness is more than the above range, it takes such a long time to form the cathode 17 that the adjacent layers may be damaged to impair the performance.

In the above description, explanation is given for an organic EL device in which the anode and the cathode are positioned on the substrate and on the side opposite to the substrate, respectively. However, the substrate may be placed on the side of the cathode. Further, the same effect can be obtained even if the positions of the blue light-emitting layer 14c and the red and green light-emitting layer 14a are exchanged for each other.

The organic EL device according to the present embodiment realizes high luminous efficiency, as compared with conventional devices. Specifically, a conventional organic EL device, which comprises a spacer layer of not oriented molecules, exhibits an external quantum efficiency of not more than about 3.5% while the device of the embodiment achieves an external quantum efficiency of not less than 7.6%.

Application examples of the organic EL device described above include a display and a lighting instrument. Figure 4 is a circuit diagram of the display according to the embodiment.

In Figure 4, a display 20 comprises pixels 21 positioned in a matrix circuit formed of lateral control lines (CL) and longitudinal data lines (DL). Each pixel 21 comprises a light-emitting device 25 and a thin film transistor (TFT) 26 connecting to the device 25. One terminal of the TFT 26 connects to the control line and the other connects to the data line. The data lines connect to a data line driving circuit 22, and the control lines connect to a control line driving circuit 23. The data line driving circuit 22 and the control line driving circuit 23 are controlled by a controller 24.

Figure 5 schematically shows a sectional view of a lighting instrument according to the embodiment.

In Figure 5, a lighting instrument 100 comprises a glass substrate 101, an anode 107, an organic EL layer 106 and a cathode 105, stacked in this order. The cathode 105 is covered with a sealing glass 102, which is fixed with UV adhesive 104. On an inner surface of the sealing glass 102, a desiccant 102 is so provided that it faces the cathode 105.

The embodiment is further explained in detail by the following examples, but they by no means restrict the embodiment.

An M-2000U spectroscopic Ellipsometer (J.A. Woollam Co.,Inc) can be, for example, used for measurement of the parameters $k_e$ and $k_o$. Measurements were taken at seven multiples angles of incident light from 45° to 75° in steps of 5°. At each angle, experimental ellipsometric parameters $k_e$ and $k_o$ were simultaneously obtained in steps of 1.6 nm throughout the spectral region from 245 to 1000 nm. The values of $k_e$ and $k_o$ did not change by rotating the samples, showing that the films have no in-plane anisotropy. An analysis of the data for estimating the parameter S can be, for example, performed using the software WVASE32 (J.A. Woollam Co., Inc), which can perform a batch analysis of all data transmission spectra.

<u>Example 1</u>

An organic EL device comprising Bpy-OXD as a spacer material was produced in the following manner. On a glass substrate, a transparent electrode of ITO (indium tin oxide) having 100 nm thickness was formed by sputtering to provide an anode. Thereafter, $\alpha$-NPD and TCTA were successively vapor-deposited in vacuum to form thin coats of 40 nm and 20 nm thicknesses, respectively, and thereby to form a hole transport layer of 60 nm thickness in total. Further, Bpy-OXD was then vapor-deposited in vacuum to form a spacer layer of 10 nm thickness. In this Example, a blue light-emitting layer was not provided by way of experiment. Instead of that, luminescence given by exciplex of the TCTA hole transport layer and the Bpy-OXD spacer layer was utilized as blue emission.

Further, in order to simply compare diffusion of triplet excitons in the spacer layer, only a red phosphorescent material was used to form a red light-emitting layer instead of the above red and green light-emitting layer. Accordingly, the organic EL device of Example 1 was designed to emit light in two colors, blue and red. The host material was Bpy-OXD, which was the same material as in the spacer layer, and the red phosphorescent material was Ir(MDQ)2(acac). They were co-deposited on the spacer layer by means of a vacuum vapor deposition system, in which the deposition rates were controlled so that the weight ratio might be 95:5, to form a red light-emitting layer of 5 nm thickness.

Since S1 energy of TCTA: Bpy-OXD exciplex was about 2.5 eV, the spacer layer could effectively prevent the energy from diffusing. Although neither T1 energy of TCTA: Bpy-OXD exciplex nor T1 energy of Bpy-OXD can be

measured even at present, emission from the red phosphorescent material was observed in the EL spectrum given off from the fabricated organic EL device. That observation indicates that triplet diffusion from the blue light-emitting layer occurred to induce the emission. It can be said, therefore, that the T1 energy of TCTA : Bpy-OXD exciplex was higher than the T1 energy of Bpy-OXD and also that the T1 energy of Bpy-OXD was higher than 2.0 eV, which was T1 energy of Ir(MDQ)2(acac).

Successively, Bpy-OXD was vapor-deposited in vacuum on the red phosphorescent light-emitting layer to form an electron transport layer of 40 nm thickness. Further, LiF was then vapor-deposited thereon in vacuum to form an electron injection layer of 0.5 nm thickness. Thereafter, aluminum was vapor-deposited in vacuum on the electron injection layer to form a cathode of 150 nm thickness. Thus, an organic EL device was produced, and finally a counter glass substrate was laminated thereon under nitrogen atmosphere with a UV curable resin to seal the produced organic EL device.

Comparative Examples 1

The procedure of Example 1 was repeated except for adopting OXD-7 in place of Bpy-OXD as the material for the spacer layer and the electron transport layer, to produce an organic EL device.

Comparative Example 2

The procedure of Example 1 was repeated except for adopting BAlq in place of Bpy-OXD as the material for the spacer layer and the electron transport layer, to produce an organic EL device.

Comparative Example 3

As the material for the spacer layer and the electron transport layer, 4P-NPD was adopted in place of Bpy-OXD to produce an organic EL device. Here, it should be noted that, although Bpy-OXD is an electron transport material, 4P-NPD is a hole transport material. It was therefore impossible to obtain good performance only by simply replacing Bpy-OXD with 4P-NPD, and hence it was necessary to change the structure of the organic EL device. Accordingly, the device of Comparative Example 3 comprised an anode, a hole transport layer, a red phosphorescent light-emitting layer, a spacer layer, a blue light-emitting layer, an electron transport layer, an electron injection layer, and a cathode, stacked in this order. Specifically, a transparent electrode of ITO (indium tin oxide) having 100 nm thickness was formed on a glass substrate by sputtering, to provide an anode. Successively, $\alpha$-NPD was vapor-deposited thereon in vacuum to form a hole transport layer of 40 nm thickness. Also in this Example, in order to simply verify diffusion of triplet excitons in the spacer layer, only a red phosphorescent material was used to form a red light-emitting layer instead of the above red and green light-emitting layer. The host material was 4P-NPD, and the red phosphorescent material was Ir(MDQ)2 (acac). They were co-deposited on the hole transport layer by means of a vacuum vapor deposition system, in which the deposition rates were controlled so that the weight ratio might be 95:5, to form a red light-emitting layer of 5 nm thickness. Further, 4P-NPD was then vapor-deposited in vacuum to form a spacer layer of 10 nm thickness. Since being capable of emitting blue fluorescence, the 4P-NPD spacer layer also served as a blue fluorescent light-emitting layer. After that, Bphene was vapor-deposited in vacuum thereon to form an electron transport layer of 40 nm thickness. Further, LiF was then vapor-deposited thereon in vacuum to form an electron injection layer of 0.5 nm thickness. Thereafter, aluminum was vapor-deposited on the electron injection layer in vacuum to form a cathode of 150 nm thickness. Thus, an organic EL device was produced, and finally a counter glass substrate was laminated thereon under nitrogen atmosphere with a UV curable resin to seal the produced organic EL device.

Evaluation of devices

The organic EL devices produced in Example and Comparative Examples were evaluated on the characteristics thereof. The evaluation was carried out by means of an instrument for measuring absolute quantum efficiency (manufactured by Hamamatsu Photonics K.K.), which was equipped with an integrating sphere, a source meter (2400 multipurpose source meter [trademark], manufactured by Keithley Instruments Inc.) and a photonic multichannel analyzer (C10027 [trademark], manufactured by Hamamatsu Photonics K.K.). As the results of the measurement, Figure 6 shows voltage-dependence of external quantum efficiencies (hereinafter, referred to as "EQEs"). The maximum EQEs of the devices produced in Example 1, Comparative Example 1, Comparative Example 2 and Comparative Example 3 were 7.6%, 0.6%, 3.3% and 2.8%, respectively.

Further, Figure 7 shows emission spectra at the current density of 5 $mA/cm^2$. Each of the devices produced in Example 1 and Comparative Examples 1 to 3 gave off dichroic emission which comprised not only blue luminescence in the wavelength range of 400 to 500 nm but also red luminescence giving a peak at about 610 nm. The red luminescence

from the device of Example 1 had higher intensity than that from any of the devices produced in Comparative examples 1 to 3, and therefore it can be presumed that triplet diffusion from the blue fluorescent material occurred efficiently to induce the red luminescence. Thus, it was verified that the organic EL device of the embodiment enabled to realize dichroic emission with higher external quantum efficiency than the devices of Comparative Examples.

Independently, the procedure of Example 1 was repeated except for changing the thickness of the Bpy-OXD spacer layer into 0 nm, 3 nm, 5 nm, 7 nm, 10 nm, 20 nm or 30 nm, to produce organic EL devices. The devices were then evaluated in the above manner by means of the instrument for measuring absolute quantum efficiency. As the results of the measurement, Figure 8 shows voltage-dependence of external quantum efficiencies. Figure 9 shows EL spectra of the produced devices. In each spectrum of Figure 9, the intensity of red luminescent peak was normalized to 1. As a result, the external quantum efficiency became not more than about 3.5% when the spacer layer had a thickness of 20 nm or more. On the other hand, when the spacer layer had a thickness of 3 nm or less, the intensity of blue luminescence was too weak to realize dichroic emission. Accordingly, it was verified that both high efficiency and dichroic emission were realized when the spacer layer had a thickness of 3 to 20 nm.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

## Claims

**1.** An organic electroluminescent device comprising
anode and cathode electrodes placed apart from each other,
a red and green light-emitting layer and a blue light-emitting layer which are placed apart from each other and which are positioned between said anode and cathode electrodes, and
a spacer layer which has a thickness of 3 nm to 20 nm inclusive and which is positioned between said red and green light-emitting layer and said blue light-emitting layer;
wherein
said spacer layer comprises a carrier transport material containing molecules capable of being oriented in the in-plane and vertical direction with an orientational order parameter of -0.5 to -0.2 inclusive.

**2.** The organic electroluminescent device according to claim 1, wherein said carrier transport material is selected from the group consisting of:

4,4-(biphenyl-4,4-diyi)bis(4,4,4-triphenylbiphenyl-4,4-diamine),
4,4-(triphenyl-4,4-diyl)bis(4,4,4-triphenylbiphenyl-4,4-di amine),
4,4'-(triphenyl-4,4'-diyl)bis(4,4'-diphenyl-4'-mono-biphenyl-biphenyl-4,4'-diamine),
1,3-bis[2-(2,2'-bipyridine-6-yl)-1,3,4-oxadizo-5-yl]-benzene,
bis-3,6-(3,5-di-pyridylphenyl)-2-phenylpyrimidine,
bis-3,6-(3,5-di-pyridylphenyl)-2-methylpyrimidine,
bis-4,6-(3,5-di-pyridylphenyl)-2-phenylpyrimidine, and
bis-4,6-(3,5-di-pyridylphenyl)-2-methylpyrimidine.

**3.** An organic electroluminescent device comprising
anode and cathode electrodes placed apart from each other,
a red and green light-emitting layer and a blue light-emitting layer which are placed apart from each other and which are positioned between said anode and cathode electrodes, and
a spacer layer which has a thickness of 3 nm to 20 nm inclusive and which is positioned between said red and green light-emitting layer and said blue light-emitting layer;
wherein
said spacer layer comprises a material selected from the group consisting of:

4,4-(biphenyl-4,4-diyl)bis(4,4,4-triphenylbiphenyl-4,4-diamine),
4,4-(triphenyl-4,4-diyf)bis(4,4,4-triphenylbiphenyl-4,4-di amine),
4,4'-(triphenyl-4,4'-diyi)bis(4,4'-diphenyl-4'-mono-biphenyl-biphenyf-4,4'-diamine),
1,3-bis[2-(2,2'-bipyridine-6-yl)-1,3,4-oxadizo-5-yl]-benzene,

bis-3,6-(3,5-di-pyridyiphenyl)-2-phenyfpyrimidine,
bis-3,6-(3,5-di-pyridylphenyl)-2-methylpyrimidine,
bis-4,6-(3,5-di-pyridylphenyl)-2-phenylpyrimidine, and
bis-4,6-(3,5-di-pyridylphenyl)-2-methylpyrimidine.

**4.** The organic electroluminescent device according to claim 1, which further comprises a hole transport layer, an electron transport layer or an electron injection layer.

**5.** A display comprising the organic electroluminescent device according to claim 1.

**6.** A lighting instrument comprising the organic electroluminescent device according to claim 1.

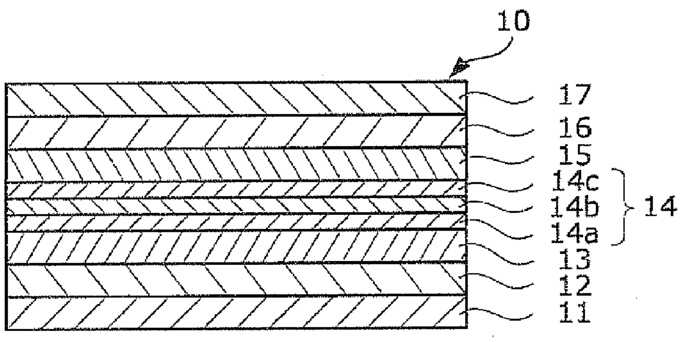


FIG. 1

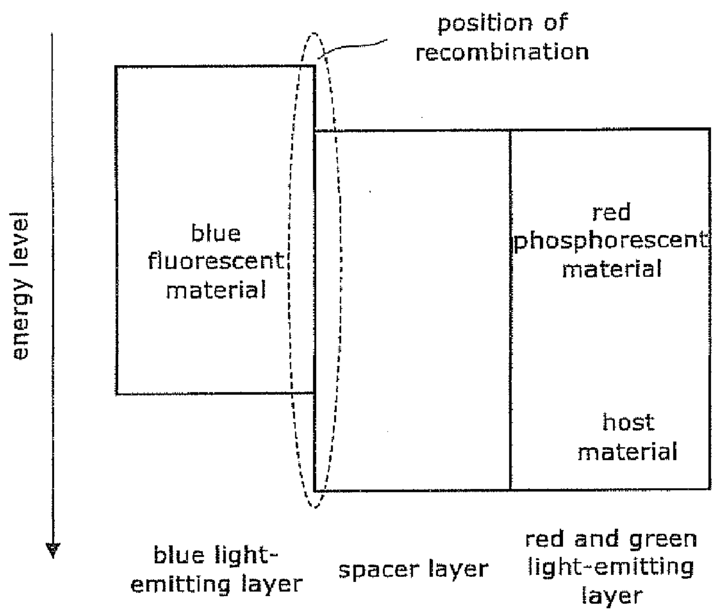


FIG. 2

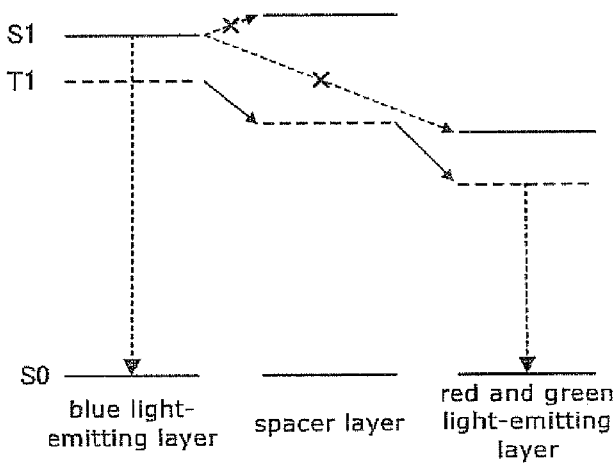


FIG. 3

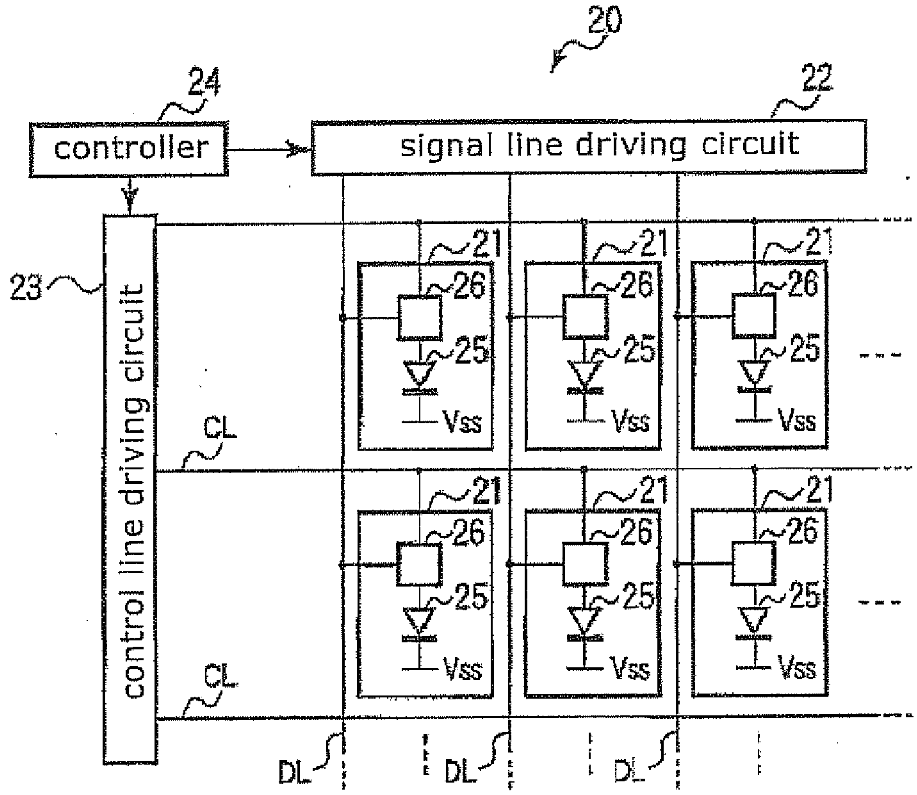
20
24
22
controller
signal line driving circuit
23
control line driving circuit
21
26
25
Vss
CL
DL

FIG. 4

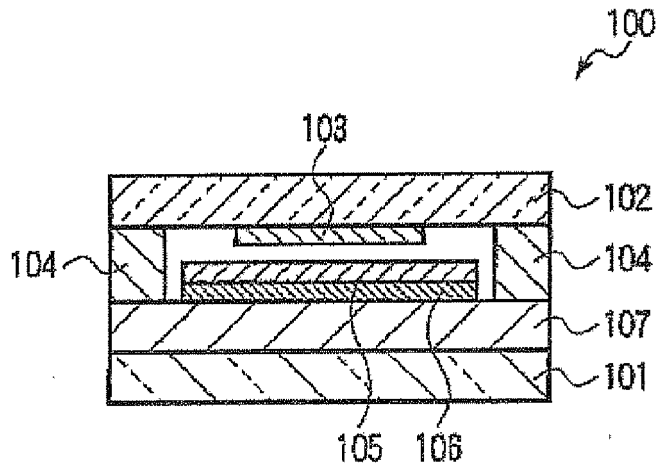
100
103
102
104
107
101
105
106

FIG. 5

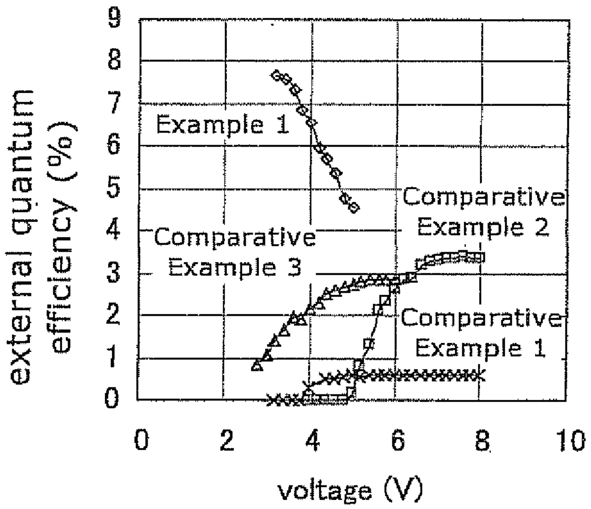
external quantum efficiency (%)
9
8
7
6
5
4
3
2
1
0
Example 1
Comparative Example 2
Comparative Example 3
Comparative Example 1
0
2
4
6
8
10
voltage (V)

FIG. 6

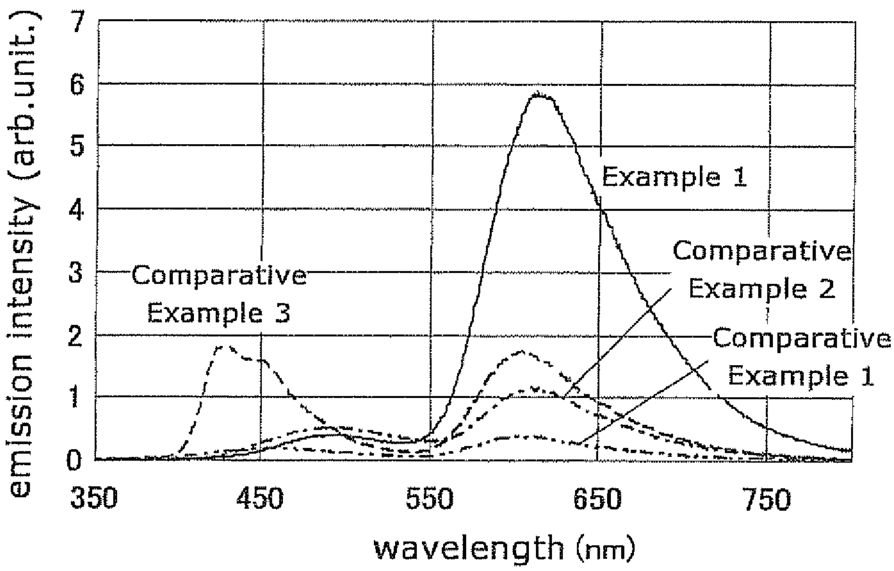
emission intensity (arb.unit.)
7
6
5
4
3
2
1
0
Example 1
Comparative Example 2
Comparative Example 3
Comparative Example 1
350
450
550
650
750
wavelength (nm)

FIG. 7

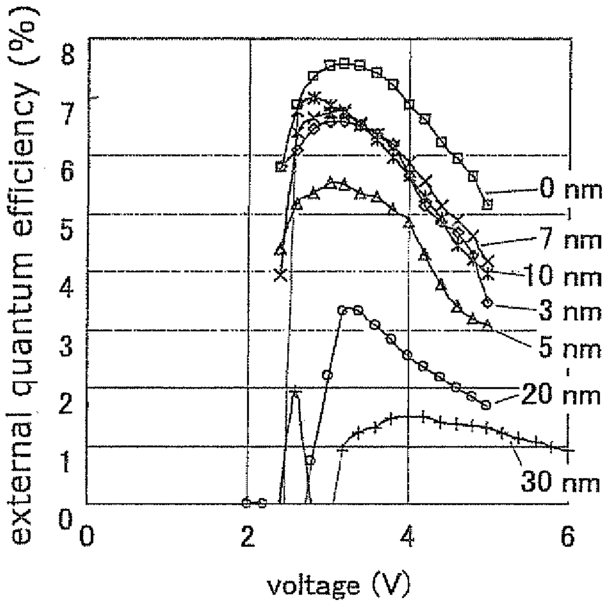
external quantum efficiency (%)
voltage (V)
0 nm
7 nm
10 nm
3 nm
5 nm
20 nm
30 nm

FIG. 8

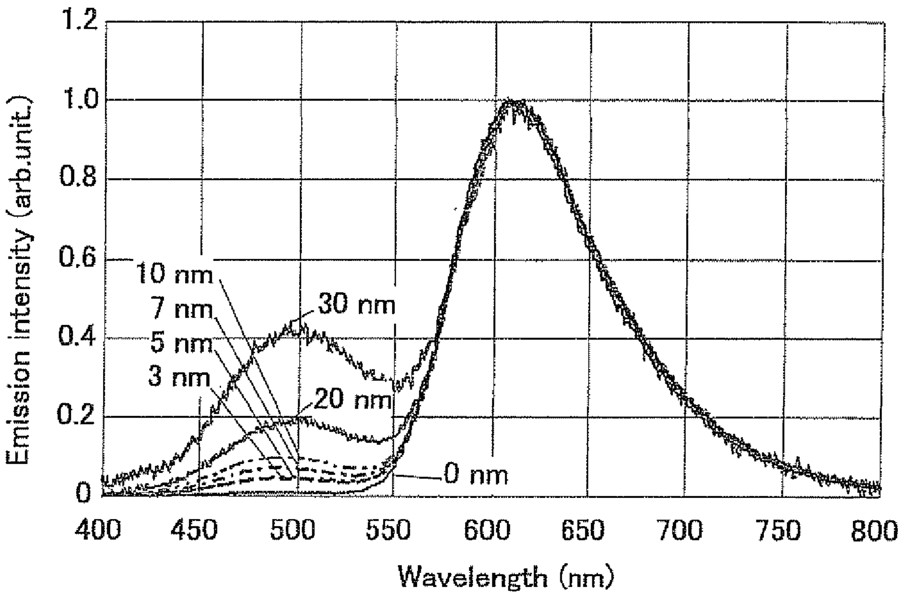
Emission intensity (arb.unit.)
Wavelength (nm)
10 nm
7 nm
5 nm
3 nm
30 nm
20 nm
0 nm

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011202828 A